# EUROPEAN PATENT SPECIFICATION

(11) **EP 3 945 323 B1**
(45) Date of publication and mention of the grant of the patent: **24.05.2023**
(21) Application number: 21188923.3
(22) Date of filing: 30.07.2021
(51) Int. Cl.: G01P 15/09, B81B 3/00, G01P 15/08

(54) **WIDE BANDWIDTH MEMS ACCELEROMETER FOR DETECTING VIBRATIONS**
MEMS-BESCHLEUNIGUNGSMESSER MIT GROSSER BANDBREITE ZUR SCHWINGUNGSDETEKTION
ACCÉLÉROMÈTRE MEMS À LARGE BANDE PASSANTE POUR DÉTECTER LES VIBRATIONS

(30) Priority: 30.07.2020 IT 202000018670
(43) Date of publication of application: 02.02.2022
(73) Proprietor: STMicroelectronics S.r.l., 20864 Agrate Brianza (MB) (IT)
(72) Inventor: GATTERE, Gabriele, 21040 CASTRONNO (VA) (IT); FEDELI, Patrick, 20030 SENAGO (MI) (IT); VALZASINA, Carlo, 20060 GESSATE (MI) (IT)
(74) Representative: Spalla, Pietro

(56) References cited:
- JP-A- H11 101 816
- US-A- 6 122 965
- US-A1- 2011 219 875
- US-A1- 2016 018 435

## Description

The present invention relates to a wide-band MEMS (MicroElectroMechanical System) accelerometer for detecting accelerations having a high frequency, as, for example, in the case of high-frequency vibrations.

As is known, systems for monitoring vibrations are today very widespread and are widely used, for example, in the context of condition-based maintenance of machinery, and in particular maintenance based upon the state of usage. In fact, it is known how monitoring of the vibrations to which a mechanical component is subject enables, for example, detection in advance of the onset of problems and/or damage.

Typically, systems for monitoring vibrations use accelerometers in order to detect, for example, variations of amplitude or frequency of the forces that act upon the components. More in general, it is known to use accelerometric sensors with a sensitivity of up to frequencies in the region of 80 kHz.

In general, sensors with different bandwidths typically find different uses. Purely by way of example, in the context of monitoring of misalignment of the shafts of electric motors, accelerometric sensors are typically used that have small bandwidths (for example, up to 3 kHz), whereas, in the context of detection of failure of bearings of fans, accelerometric sensors are used having large bandwidths (for example, up to 80 kHz).

All this having been said, there is felt the need to find a good balance between the costs and the performance of the sensors. In this connection, MEMS sensors have been developed, as described, for example, in F. Gerfers et al., "Sub-pg Ultra-Low-Noise MEMS Accelerometers Based on CMOS-Compatible Piezoelectric AlN Thin Films", Transducers & Eurosensors 2007, which describes the use of a membrane structure, or else in T. Kobayashi et al., "A digital output piezoelectric accelerometer using CMOS-compatible AlN thin film", Transducers 2009, which describes is the use of a structure that includes a cantilever element.

In general, MEMS membrane structures are subject to residual mechanical stresses on account of the presence of distributed constraints and/or constraints in a relatively high number, which act upon the membrane; such mechanical residual stresses lead to a degradation in the performance. Instead, MEMS structures with cantilever elements prove less subject to residual mechanical stresses on account of the presence of a single constraint; however, these are substantially sensitive only to out-of-plane accelerations; i.e., they are basically uniaxial. Moreover, in the presence of a number of cantilever elements, the resonance frequencies of the cantilever elements inevitably differ from one another, with consequent reduction of sensitivity.

JP H11 101816 A discloses an angular acceleration sensor including mobile masses which are fixed to ends of corresponding cantilever elements. US 6 122 965 discloses a sensor including cantilevered masses, which are connected by bending beams to an outer frame.

The aim of the present invention is consequently to provide an accelerometer that will overcome at least in part the drawbacks of the prior art.

According to the present invention, a MEMS accelerometer is provided, as defined in the annexed claims.

For a better understanding of the present invention, preferred embodiments thereof will now be described, purely by way of non-limiting example, with reference to the attached drawings, wherein:
- Figure 1 is a schematic cross-sectional view of an accelerometer, taken along a line of section I-I represented in Figure 2;
- Figure 2 is a schematic top view of a cross-section of the accelerometer illustrated in Figure 1, taken along a line of section II-II represented in Figure 1;
- Figures 3 and 4 are schematic side views of portions of the accelerometer illustrated in Figures 1-2 in different operating conditions;
- Figures 5 and 6 are schematic side views of portions of the accelerometer illustrated in Figures 1-2 in different operating conditions;
- Figure 7 is a schematic top view of a cross-section of an accelerometer; and
- Figures 8A-8C are schematic top views of the accelerometer illustrated in Figure 7 in different operating conditions.

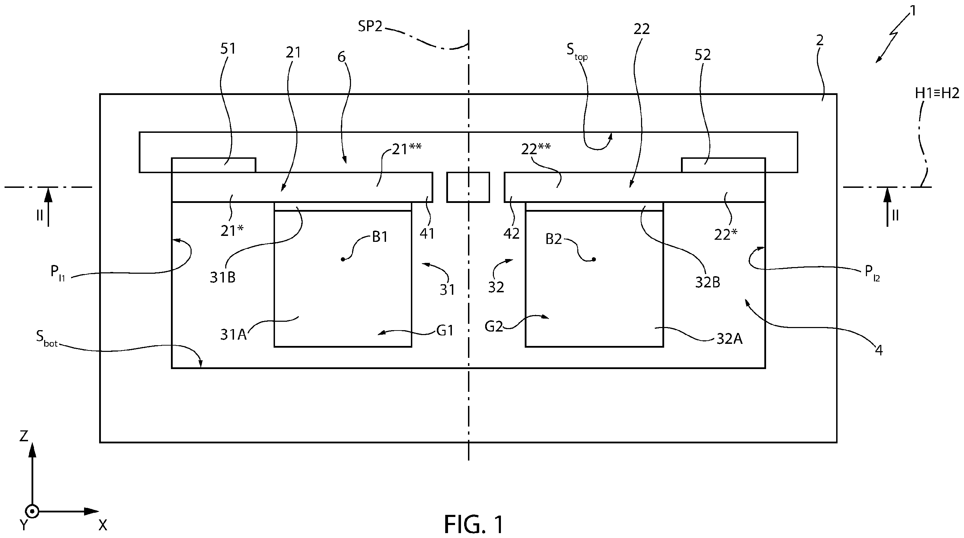

Figure 1 shows a MEMS accelerometer 1, which comprises a supporting structure 2, which delimits a cavity 4, extending inside which is a sensitive structure 6. Without this implying any loss of generality, the supporting structure 2 may have a closed shape (for example, externally it may have the shape of a parallelepiped), in which case the cavity 4 is closed; i.e., it is not in fluid communication with the outside world. In addition, the supporting structure 2 is, for example, of silicon.

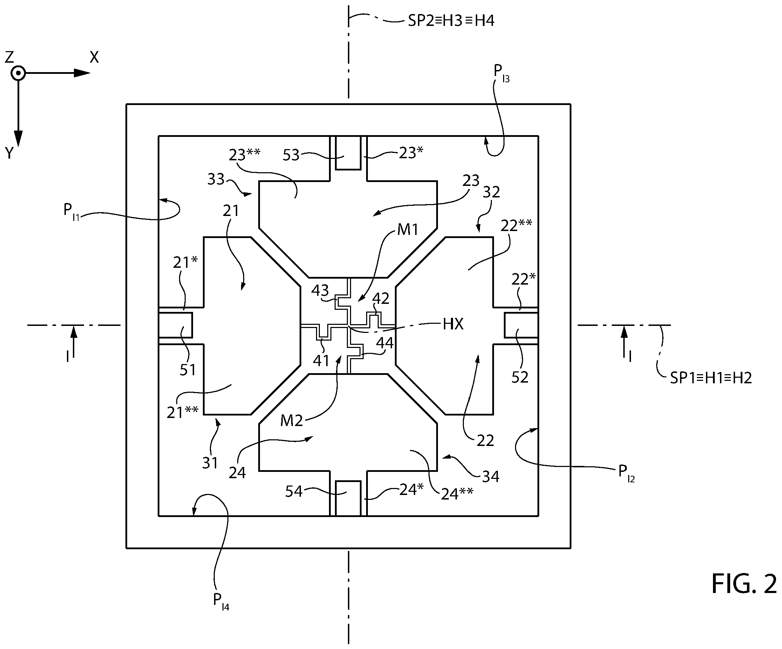

In greater detail, assuming an orthogonal reference system XYZ, the cavity 4 is delimited at the top and at the bottom, respectively, by a top surface Sₜₒₚ and a bottom surface S_{bot}, which are parallel to the plane XY; moreover, the cavity 4 is delimited laterally by a first side wall Pₗ₁ and a second side wall Pₗ₂, which are parallel to the plane YZ, and by a third side wall Pₗ₃ and a fourth side wall Pₗ₄ (visible in Figure 2), which are parallel to the plane XZ. The top surface Sₜₒₚ, the bottom surface S_{bot}, and the first and second side walls Pₗ₁, Pₗ₂ are formed by the supporting structure 2.

The sensitive structure 6 is constrained to the first, second, third, and fourth side walls Pₗ₁, Pₗ₂ Pₗ₃, Pₗ₄ so as to be suspended over the bottom surface S_{bot}, at a distance therefrom.

In particular, the sensitive structure 6 comprises a first cantilever element 21, a second cantilever element 22, a third cantilever element 23, and a fourth cantilever element 24, as well as a first suspended group G1, a second suspended group G2, a third suspended group G3, and a fourth suspended group G4, and a first spring element 41, a second spring element 42, a third spring element 43, and a fourth spring element 44.

In detail, the first, second, third, and fourth cantilever elements 21, 22, 23, 24 are the same as one another and are arranged, in resting conditions, in a co-planar way, at a same height along the axis Z. In particular, the first, second, third, and fourth cantilever elements 21, 22, 23, 24 have a planar shape; purely by way of example, the first, second, third, and fourth cantilever elements 21, 22, 23, 24 may have a thickness (measured along the axis Z) comprised between 10 um and 20 um.

Furthermore, the first, second, third, and fourth cantilever elements 21, 22, 23, 24 are, for example, of silicon.

In greater detail, each one of the first, second, third, and fourth cantilever elements 21, 22, 23, 24 includes a respective deformable portion (designated, respectively, by 21*, 22*, 23* and 24*) and a respective distal portion (designated, respectively, by 21**, 22**, 23** and 24**).

The deformable portions 21*, 22*, 23* and 24* of the first, second, third, and fourth cantilever elements 21, 22, 23, 24 have the shape of parallelepipeds.

In particular, assuming a first plane of symmetry SP1 and a second plane of symmetry SP2, parallel, respectively, to the plane ZX and to the plane ZY, the deformable portions 21*, 22* of the first and second cantilever elements 21, 22 are elongated in a direction parallel to the axis X and are set in a symmetrical way with respect to the second plane of symmetry SP2, at a distance from one another. In greater detail, if H1 and H2 are the directions in which the centroidal axes of the deformable portions 21*, 22* of the first and second cantilever elements 21, 22, respectively, extend, the directions H1 and H2 to a first approximation coincide with and are parallel to the axis X. In addition, the deformable portion 21* of the first cantilever element 21 and the deformable portion 22* of the second cantilever element 22 have respective first ends, which are, respectively, fixed to the first and second side walls Pₗ₁, Pₗ₂, and respective second ends. In practice, the first and second cantilever elements 21, 22 are arranged so as to be opposite to one another.

The deformable portions 23*, 24* of the third and fourth cantilever elements 23, 24 are elongated in a direction parallel to the axis Y and are set in a symmetrical way with respect to the first plane of symmetry SP1, at a distance from one another. In greater detail, if H3 and H4 are the directions in which the centroidal axes of the deformable portions 23*, 24* of the third and fourth cantilever elements 23, 24 extend, respectively, to a first approximation, the directions H3 and H4 are found to coincide and to be parallel to the axis Y. In addition, the deformable portions 23*, 24* of the third and fourth cantilever elements 23, 24 have respective first ends, which are, respectively, fixed to the third and fourth side walls Pₗ₃, Pₗ₄, and respective second ends. In practice, the third and fourth cantilever elements 23, 24 are arranged so as to be opposite to one another.

The first and second planes of symmetry SP1, SP2 intersect along an axis HX parallel to the axis Z. Furthermore, the distal portions 21**, 22**, 23**, 24** of the first, second, third, and fourth cantilever elements 21, 22, 23, 24 are, respectively, fixed with respect to the second ends of the deformable portions 21*, 22*, 23*, 24* of the first, second, third, and fourth cantilever elements 21, 22, 23, 24, and overlie, respectively, the first, second, third, and fourth suspended groups G1, G2, G3, G4. As explained hereinafter, and without this implying any loss of generality, in top plan view the distal portions 21**, 22**, 23**, 24** of the first, second, third, and fourth cantilever elements 21, 22, 23, 24 have, respectively, the same shape as the first, second, third, and fourth suspended groups G1, G2, G3, G4.

In detail, the first, second, third, and fourth suspended groups G1, G2, G3, G4 are the same as one another, have for example the shape of prisms with polygonal bases with axes parallel (in resting conditions) to the axis Z; i.e., their sections in planes parallel to the plane XY do not vary as the co-ordinate along the axis Z varies. The details regarding the shape of the suspended groups are in any case irrelevant for the purposes of operation of the MEMS accelerometer 1. Purely by way of example, in Figure 2 the aforementioned prisms have a base (parallel to the plane XY) that has the plane shape that can be obtained by juxtaposition of i) an isosceles trapezium with the minor base facing the axis HX, and ii) a rectangle with the major side that coincides with the major base of the aforementioned isosceles trapezium. Once again without this implying any loss of generality, the bases of the isosceles trapezia defined in top plan view by the first and second suspended groups G1, G2 are parallel to the axis Y, whereas the bases of the isosceles trapezia defined in top plan view by the third and fourth suspended groups G3, G4 are parallel to the axis X.

The first, second, third, and fourth suspended groups G1, G2, G3, G4 are, respectively, fixed underneath the distal portions 21**, 22**, 23**, 24** of the first, second, third, and fourth cantilever elements 21, 22, 23, 24.

Without this implying any loss of generality, in what follows it is assumed that each one of the first, second, third, and fourth suspended groups G1, G2, G3, G4 is formed by a corresponding main region (designated, respectively, by 31A, 32A, 33A, 34A), for example, of silicon, and by a corresponding top layer (designated, respectively, by 31B, 32B, 33B, 34B), for example, of silicon oxide.

In greater detail, with reference for example to the first suspended group G1 (but the same considerations also apply to the second, third, and fourth suspended groups G2, G3, G4), the corresponding top layer 31B is fixed at the top to the distal portion 21** of the first cantilever element 21 and overlies the underlying main region 31A. As mentioned previously and without this implying any loss of generality, the distal portion 21** of the first cantilever element 21, the underlying top layer 31B and the underlying main region 31A have a same shape in top plan view and moreover form a mobile mass 31, referred to in what follows as the first mobile mass 31. Purely by way of example, the top layer 31B and the underlying main region 31A have a thickness (measured along the axis Z) comprised, for example, respectively, in the ranges 1-2 um and 250-500 um. Likewise, the distal portions 22**, 23**, 24** of the second, third, and fourth cantilever elements 22, 23, 24 form, respectively, a second mobile mass 32, a third mobile mass 33, and a fourth mobile mass 34, respectively, with the underlying i) top layer 32B and main region 32A, ii) top layer 33B and main region 33A, and iii) top layer 34B and main region 34A.

In practice, the first suspended mass 31 and the second suspended mass 32 are arranged in a symmetrical way with respect to the second plane of symmetry SP2. Likewise, the third suspended mass 33 and the fourth suspended mass 34 are arranged in a symmetrical way with respect to the first plane of symmetry SP1. From another standpoint, the first, second, third, and fourth suspended masses 31, 32, 33, 34 are arranged at a same radial distance from the axis HX and are set at equal angular distances apart from one another of 90° so as to be arranged according to the vertices of a hypothetical rhombus.

The first, second, third, and fourth spring elements 41, 42, 43, 44 each have a folded elongated shape, are, for example, of silicon, and may have, in resting conditions, the same thickness (along Z) as the first, second, third, and fourth cantilever elements 21, 22, 23, 24, with which they are co-planar.

In greater detail, each one of the first, second, third, and fourth spring elements 41, 42, 43, 44 has a respective first end and a respective second end. The first ends of the first, second, third, and fourth spring elements 41, 42, 43, 44 are fixed, respectively, to the distal portions 21**, 22**, 23**, 24** of the first, second, third, and fourth cantilever elements 21, 22, 23, 24, with which they are in direct contact and form a single piece. The first ends of the first, second, third, and fourth spring elements 41, 42, 43, 44 are therefore fixed, respectively, to the first, second, third, and fourth mobile masses 31, 32, 33, 34. The second ends of the first, second, third, and fourth spring elements 41, 42, 43, 44 are fixed to one another, around the axis HX, so as to form a single cross-shaped piece.

The first and second spring elements 41, 42 are rigid in a direction parallel to the axis Z, are compliant in a direction parallel to the axis X, and form a first spring structure M1. The third and fourth spring elements 43, 44 are rigid in a direction parallel to the axis Z, are compliant in a direction parallel to the axis Y, and form a second spring structure M2.

In practice, the distal portions 21**, 22** of the first and second cantilever elements 21, 22 are connected to one another by the first spring structure M1, which is compliant in a direction parallel to the axis X and is rigid in a direction parallel to the axis Z. Likewise, the distal portions 23**, 24** of the third and fourth cantilever elements 23, 24 are connected to one another by the second spring structure M2, which is compliant in a direction parallel to the axis Y and is rigid in a direction parallel to the axis Z. As mentioned previously, the first and second spring structures M1, M2 intersect one another and form, respectively, a first arm and a second arm of a cross-shaped structure, which are perpendicular to one another.

This having been said, the first spring structure M1 has a stiffness in the direction H1 (equivalently, H2) that is lower than the stiffness in the direction H1 of the deformable portions 21*, 22* of the first and second cantilever elements 21, 22. The second spring structure M2 has a stiffness in the direction H3 (equivalently, H4) that is lower than the stiffness in the direction H3 of the deformable portions 23*, 24* of the third and fourth cantilever elements 23, 24.

In addition, the centroids of the first and second mobile masses 31, 32 (represented qualitatively in Figure 1, where they are designated, respectively, by B1 and B2) are located at lower a height (measured in a direction parallel to the axis Z) than the directions H1, H2. In addition, the centroid B1 is located at a value of co-ordinate along X greater than the second end of the deformable portion 21* of the first cantilever element 21; the centroid B2 is located at a value of co-ordinates along X lower than the second end of the deformable portion 22* of the first cantilever element 22. Equivalently, given an imaginary plane parallel to the plane XY and containing the directions H1, H2, the centroids B1, B2 of the first and second mobile masses 31, 32 are arranged underneath said imaginary plane and, along the axis X, are staggered, with respect to the second ends of the deformable portions of the corresponding cantilever elements, in the direction of the axis HX. In other words still, in resting conditions, the first and second mobile masses 31, 32 are vertically and laterally staggered with respect to the first and second deformable portions 21*, 22* of the first and second cantilever elements 21, 22.

To a first approximation, and without this implying any loss of generality, the centroids B1, B2 of the first and second mobile masses 31, 32 are co-planar with respect to one another and with respect to the directions H1, H2; to a first approximation, the centroids B1, B2 and the directions H1, H2 lie in the first plane of symmetry SP1. Likewise, albeit not illustrated, the centroids of the third and fourth mobile masses 33, 34 are located at a smaller height than the directions H3, H4; to a first approximation they lie, together with the latter directions, in the second plane of symmetry SP2 and are laterally staggered, along the axis Y and in the direction of the axis HX, with respect to the second ends of the deformable portions 23*, 24* of the third and fourth cantilever elements 23, 24.

The MEMS accelerometer 1 further comprises a first piezoelectric detection structure 51, a second piezoelectric detection structure 52, a third piezoelectric detection structure 53, and a fourth piezoelectric detection structure 54, which are, for example, the same as one another and, albeit not illustrated, each comprise a respective pair of electrodes, interposed between which is a respective region of piezoelectric material (for example, of PZT).

Without this implying any loss of generality, the first, second, third, and fourth piezoelectric detection structures 51, 52, 53, 54 extend, respectively, on the deformable portions 21*, 22*, 23*, 24* of the first, second, third, and fourth cantilever elements 21, 22, 23, 24, and are therefore laterally staggered, respectively, with respect to the first, second, third, and fourth mobile masses 31, 32, 33, 34. Moreover, once again without this implying any loss of generality, the first, second, third, and fourth piezoelectric detection structures 51, 52, 53, 54 extend laterally as far as on the first ends of the deformable portions 21*, 22*, 23*, 24* of the first, second, third, and fourth cantilever elements 21, 22, 23, 24, which, as has been said, are fixed to the supporting structure 2 and represent areas subject to high deformations. Likewise, albeit not illustrated, variants are possible in which the first, second, third, and fourth piezoelectric detection structures 51, 52, 53, 54 extend partially also on part of the supporting structure 2.

In greater detail, considering, for example, the first piezoelectric detection structure 51 (but the same considerations also apply to the other piezoelectric detection structures), this is set, at a distance, above the centroidal axis of the ensemble formed by the deformable portion 21* of the first cantilever element 21 and by the same first piezoelectric detection structure 51, which to a first approximation can be assumed as coinciding with the centroidal axis of just the deformable portion 21* of the first cantilever element 21, and therefore with the aforementioned direction H1. Furthermore, the first piezoelectric detection structure 51 (but the same considerations also apply to the other piezoelectric detection structures and to the corresponding centroidal axes) has a planar shape symmetrical with respect to the underlying centroidal axis of the deformable portion 21* of the first cantilever element 21; i.e., in top plan view, it is divided into two equal parts by said centroidal axis.

All this having been said, considering the pair formed by the first cantilever element 21 and the first mobile mass 31, and neglecting for the moment the presence of the first spring structure M1, and therefore considering for simplicity the first mobile mass 31 as being decoupled from the second, third, and fourth mobile masses 32, 33, 34, we find what is described in what follows.

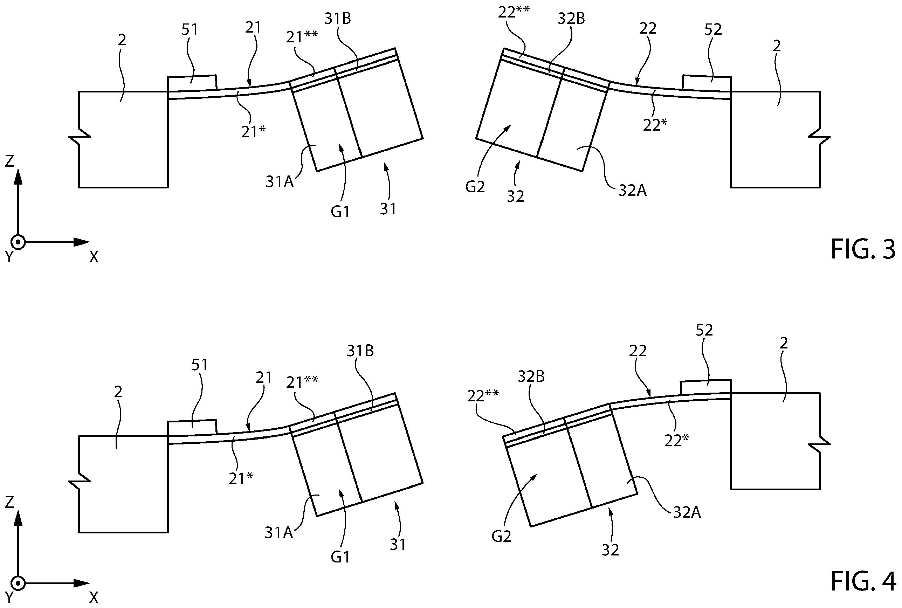

In the case where, as illustrated in Figure 3, the first mobile mass 31 is subjected to an (inertial) acceleration parallel to the axis Z (for example, directed upwards, as in the case of a vibration such that the supporting structure 2 is subjected to an acceleration directed along the axis Z, but downwards), the deformable portion 21* of the first cantilever element 21 is subjected to a bending moment directed in a direction parallel to the axis Y, which is generated on account of the staggering along the axis X between the first mobile mass 31 and the second end of the deformable portion 21* of the first cantilever element 21. This moment causes a deformation, and in particular a compression, of the first piezoelectric detection structure 51, since, as explained previously, the first piezoelectric detection structure 51 is vertically staggered with respect to the neutral axis of the ensemble formed by the deformable portion 21* of the first cantilever element 21 and the first piezoelectric detection structure 51, this neutral axis to a first approximation coinciding with the aforementioned centroidal axis of the ensemble formed by the deformable portion 21* of the first cantilever element 21 and the first piezoelectric detection structure 51. Consequently, the first piezoelectric detection structure 51 generates a voltage V1 between its own electrodes, which depends precisely upon the aforementioned bending moment, and therefore upon the amplitude of the acceleration parallel to the axis Z.

Furthermore, even in the case where, as shown in Figure 4, the first mobile mass 31 is subjected to an (inertial) acceleration parallel to and concordant with the axis X (as in the case of a vibration such that the supporting structure 2 is subjected to an acceleration directed along the axis X, but discordant with respect thereto), the deformable portion 21* of the first cantilever element 21 is subjected to a corresponding bending moment, which is again directed in a direction parallel to the axis Y, because, as explained previously, the centroid B1 of the first mobile mass 31 is located underneath the centroidal axis of the ensemble formed by the deformable portion 21* of the first cantilever element 21 and the first piezoelectric detection structure 51. This bending moment causes a deformation (in particular, a compression) of the first piezoelectric detection structure 51 so that the voltage V1 depends upon the bending moment itself, and therefore upon the amplitude of the acceleration parallel to the axis X. The bending moments to which the deformable portion 21* of the first cantilever element 21 is subjected in the case of inertial accelerations parallel, respectively, to the axis X or to the axis Z are parallel to and concordant with one another.

Instead, in the case (not illustrated) where the first mobile mass 31 is subjected to an (inertial) acceleration parallel to and concordant with the axis Y (as in the case of a vibration such that the supporting structure 2 is subjected to an acceleration directed along the axis Y, but discordant with respect thereto), the deformable portion 21* of the first cantilever element 21 is subjected to a torsion about the direction H1, which entails that part of the first piezoelectric detection structure 51 is subjected to a tension and part is subjected to compression, with the consequence that the voltage V1 is approximately zero.

Considering, instead, the pair formed by the second cantilever element 22 and the second mobile mass 32, and again neglecting the presence of the first spring structure M1, we find what is described hereinafter.

In the conditions referred to in Figure 3, the second mobile mass 32 is subjected to an acceleration parallel to and concordant with the axis Z. The deformable portion 22* of the second cantilever element 22 is therefore subjected to a bending moment directed in a direction parallel to the axis Y and with opposite sense with respect to the bending moment to which the deformable portion 21* of the first cantilever element 31 is simultaneously subjected so that the second piezoelectric structure 52 undergoes a deformation symmetrical with respect to the deformation undergone by the first piezoelectric structure 51 (in particular, a compression). Consequently, the second piezoelectric detection structure 52 generates a voltage V2 between its own electrodes, which indicates the amplitude of the acceleration parallel to the axis Z. Ideally, in the conditions referred to in Figure 3, the voltage V1 and the voltage V2 are equal.

In the conditions referred to in Figure 4, the second mobile mass 32 is subjected to an acceleration parallel to and concordant with the axis X. The deformable portion 22* of the second cantilever element 22 is subjected to a corresponding bending moment, which is parallel to and concordant with the bending moment to which the deformable portion 21* of the first cantilever element 21 is simultaneously subjected. In fact, while the first mobile mass 31 and the second end of the deformable portion 21* of the first cantilever element 21 tend to rise, the second mobile mass 32 and the second end of the deformable portion 22* of the second cantilever element 22 tend to drop. Consequently, whereas the deformation of the first piezoelectric detection structure 51 is of a compressive type, the second piezoelectric detection structure 52 is of a tensile type and the voltage V2 depends upon the strain undergone by the second piezoelectric detection structure 52. The voltage V2 consequently has a sign opposite to that of the voltage V1. Ideally, in the conditions referred to in Figure 4, the voltage V1 and the voltage V2 have the same magnitude and opposite sign.

By means of an electronic circuitry of a per se known type and here not illustrated, it is thus, for example, possible to generate a signal sVZ' = V1 + V2 and a signal sVX = V1 - V2, which, respectively, indicate the acceleration along Z and the acceleration along X to which the MEMS accelerometer 1 is subjected. In this connection, the bottom electrodes of the first and second piezoelectric detection structures 51, 52 can be set to ground, and the top electrodes of the first and second piezoelectric detection structures 51, 52 can be connected so as to generate the aforementioned signals sVZ' and sVX.

Similar considerations apply to the subsystem formed by the third cantilever element 23, the third suspended mass 33, and the third piezoelectric detection structure 53, and by the fourth cantilever element 24, the fourth suspended mass 34, and the fourth piezoelectric detection structure 54.

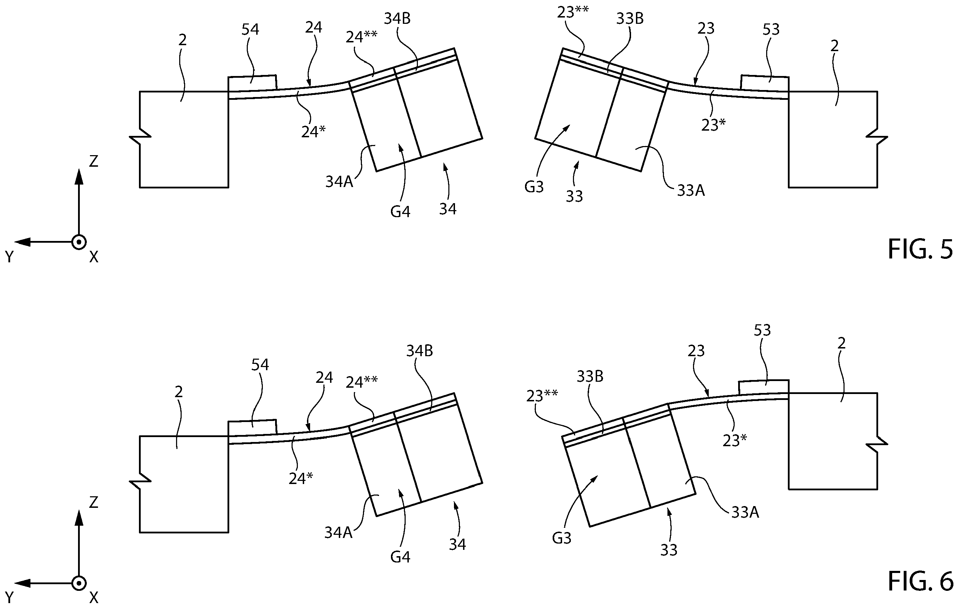

In particular, as illustrated in Figure 5, which regards the same conditions as those of Figure 3, i.e., in the presence of an inertial acceleration along Z, the deformable portions 23*, 24* of the third and fourth cantilever elements 23, 24 are subjected to parallel and opposite bending moments, which cause a same type of deformation (compression or tension, according to the sense of the acceleration) of the third and fourth piezoelectric detection structures 53, 54. Instead, as illustrated in Figure 6, which regards the case where an inertial acceleration along Y is present, the deformable portions 23*, 24* of the third and fourth cantilever elements 23, 24 are subjected to parallel and concordant bending moments, which cause deformations (compression or tension) of a type opposite to those of the third and fourth piezoelectric detection structures 53, 54. Consequently, if V3 and V4 are the voltages generated, respectively, by the third and fourth piezoelectric detection structures 53, 54, and if sVZ" and sVY are the signals equal to V3 + V4 and V3 - V4, respectively, the signals sVZ" and sVY, respectively, indicate the acceleration along Z and the acceleration along Y to which the MEMS accelerometer 1 is subjected. Furthermore, in the presence of an acceleration along X, the voltages V3 and V4 are substantially zero.

In addition, with reference, for example, to the elastic coupling present, thanks to the first spring structure M1, between the first and second mobile masses 31, 32, we find what is described hereinafter.

As mentioned previously, in the direction H1, and therefore in a direction parallel to the axis X, the first spring structure M1 is compliant, unlike the deformable portions 21*, 22* of the first and second cantilever elements 21, 22. Consequently, any possible undesired mechanical stresses that act upon the supporting structure 2, for example due to the package (not illustrated), are compensated by the first spring structure M1, without causing any deformation of the deformable portions 21*, 22* of the first and second deformable elements 21, 22, and therefore without altering the voltages generated by the first and second piezoelectric detection structures 51, 52.

For instance, the first spring structure M1 can absorb the stresses due to gluing or welding of the supporting structure 2 to a respective base of the package, which would otherwise induce tensile or compressive states of the first and second piezoelectric detection structures 51, 52.

In addition, the deformable portions 21*, 22* of the first and second cantilever elements 21, 22, the first and second mobile masses 31, 32, and the first spring structure M1 form a mechanical system, which, if for the moment the presence of the second spring structure M2 and of the third and fourth cantilever elements 23, 24 are neglected, can be sized so that the mode in which the first and second mobile masses 31, 32 oscillate in phase has a desired frequency, lower than the frequency of the spurious mode, in which the first and second mobile masses 31, 32 oscillate in phase opposition. In this connection, in the absence of the first spring structure M1, the mechanical system formed by the deformable portion 21* of the first cantilever element 21 and by the first mobile mass 31 and the mechanical system formed by the deformable portion 22* of the second cantilever element 22 and by the second mobile mass 32 would be independent and would have independent modes of oscillation, with different resonance frequencies, which would require normalization of the electrical responses supplied by the first and second piezoelectric detection structures 51, 52 so as to neutralize the differences due to the different resonance frequencies of the modes of oscillation of the aforementioned two independent mechanical systems. In practice, there would in any case be a reduction of sensitivity.

The same considerations also apply to the second spring structure M2, to the direction H3, and to the deformable portions 23*, 24* of the third and fourth cantilever elements 23, 24, which absorb undesired stresses present on the first ends of the third and fourth cantilever elements 23, 24.

In practice, the deformable portions 23*, 24* of the third and fourth cantilever elements 23, 24, the third and fourth mobile masses 33, 34, and the second spring structure M2 form the aforementioned mechanical system, together with the deformable portions 21*, 22* of the first and second cantilever elements 21, 22, with the first and second mobile masses 31, 32, and with the first spring structure M1. This mechanical system can thus be sized so that the so-called operating mode, i.e., the mode excited by the accelerations to be detected, is the first mode, i.e., the mode in which the first, second, third, and fourth mobile masses 31, 32, 33, 34 oscillate in phase.

Albeit not illustrated, there may in any case be envisaged variants in which, for example, the third and fourth cantilever elements 23, 24, the third and fourth suspended groups G3, G4, and the second spring structure M2 are absent, in which case the MEMS accelerometer 1 is insensitive to accelerations directed in a direction parallel to the axis Y. Likewise, variants are possible in which the first and second cantilever elements 21, 22, the first and the second suspended groups G1, G2, and the first spring structure M1 are absent, in which case the MEMS accelerometer 1 is insensitive to accelerations directed in a direction parallel to the axis X.

In practice, the embodiment illustrated in Figure 2 makes it possible to benefit from a high resilience in regard to undesired mechanical stresses present at the ends of the cantilever elements fixed to the supporting structure 2, as well as a high sensitivity also for vibrations at a relatively high frequency (for example, 10-20 kHz).

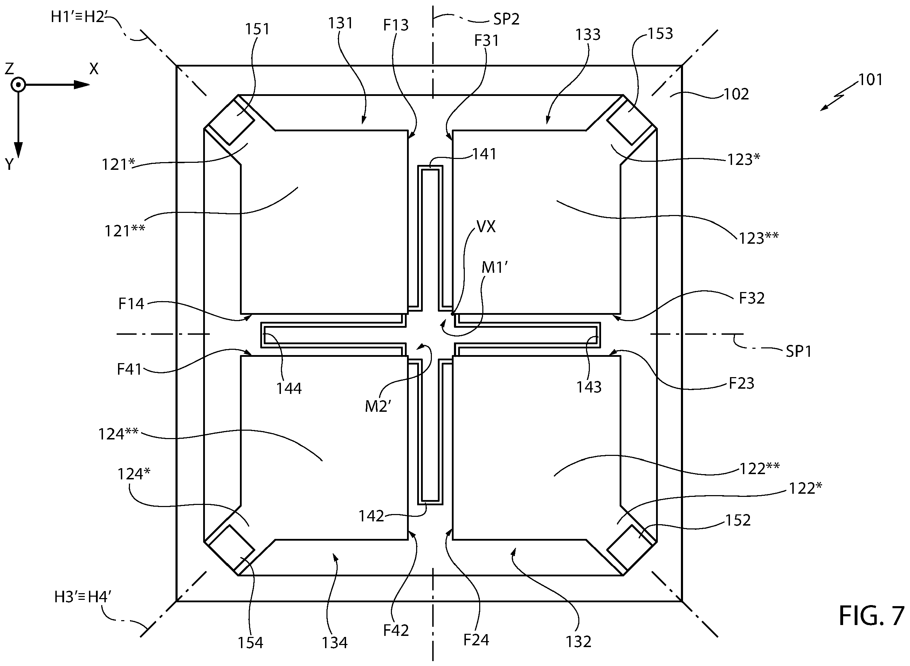

According to a different embodiment (illustrated in Figure 7), where the MEMS accelerometer is designated by 101, the shape and arrangement of the mobile masses and of the spring structures are different from what has been described previously, as explained in detail hereinafter, where parts that have already been mentioned previously are designated by the same reference numbers, increased by one hundred, except where otherwise specified.

In detail, the first, second, third, and fourth mobile masses 131, 132, 133, 134 have approximately the shape of parallelepipeds, are arranged at a same radial distance from the axis HX and are set at equal angular distances apart so as to be arranged at the vertices of a hypothetical square.

In particular, the first, second, third, and fourth mobile masses 131, 132, 133, 134 have approximately the shape of parallelepipeds with side walls parallel alternatively to the plane XZ or to the plane YZ, in resting conditions. Moreover, the first and third mobile masses 131, 133 are aligned in a direction parallel to the axis X; likewise, the second and fourth mobile masses 132, 134 are aligned in a direction parallel to the axis X. Furthermore, the first and fourth mobile masses 131, 134 are aligned in a direction parallel to the axis Y; likewise, the second and third mobile masses 132, 133 are aligned in a direction parallel to the axis Y.

In resting conditions, the deformable portions 121*, 122* of the first and second cantilever elements 121, 122 have centroidal axes that lie, respectively, in a direction H1' and a direction H2', which are parallel to the plane XY, are parallel to one another, and to a first approximation coincide. In addition, the directions H1', H2' are inclined by -45° with respect to the axis X. To a first approximation, the directions H1', H2' coincide also with the centroidal axes of the two ensembles formed, respectively, i) by the deformable portion 121* of the first cantilever element 121 and the first piezoelectric detection structure 151, and ii) by the deformable portion 122* of the second cantilever element 122 and the second piezoelectric detection structure 152, said centroidal axes moreover in turn coinciding, to a first approximation, with the neutral axes of the corresponding ensembles.

The deformable portions 123*, 124* of the third and fourth cantilever elements 123, 124 have centroidal axes that lie, respectively, in a direction H3' and a direction H4', which are parallel to the plane XY, are parallel to one another, and to a first approximation coincide. In addition, the directions H3', H4' are inclined by +45° with respect to the axis X. The directions H3', H4' coincide, to a first approximation, also with the centroidal axes of the two ensembles formed, respectively, i) by the deformable portion 123* of the third cantilever element 123 and the third piezoelectric detection structure 153, and ii) by the deformable portion 124* of the fourth cantilever element 124 and the fourth piezoelectric detection structure 154, said centroidal axes moreover in turn coinciding, to a first approximation, with the neutral axes of the corresponding ensembles.

The deformable portions 121*, 122*, 123*, 124* of the first, second, third, and fourth cantilever elements 121, 122, 123, 124 are set, in top plan view, between the supporting structure 102 and, respectively, the corresponding distal portions 121**, 122**, 123**, 124**, which form, respectively, the first, second, third, and fourth mobile masses 131, 132, 133, 134. Furthermore, the deformable portions 121*, 122*, 123*, 124* of the first, second, third, and fourth cantilever elements 121, 122, 123, 124 are, respectively, overlaid by the first, second, third, and fourth piezoelectric detection structures 151, 152, 153, 154.

The first, second, third, and fourth spring elements 141, 142, 143, 144 each have a folded elongated shape, are, for example, of silicon and may have, in resting conditions, the same thickness (along Z) as the first, second, third, and fourth cantilever elements 121, 122, 123, 124, with which they are co-planar.

In greater detail, in what follows designated by F13 and F31 are the side surfaces parallel to and facing the second plane of symmetry SP2 of the first suspended mass 131 and, respectively, the third suspended mass 133; likewise, designated by F24 and F42 are the side surfaces parallel to and facing the second plane of symmetry SP2 of the second suspended mass 132 and, respectively, the fourth suspended mass 134. In addition, designated by F14 and F41 are the side surfaces parallel to and facing the first plane of symmetry SP1 of the first suspended mass 131 and, respectively, the fourth suspended mass 134; likewise, designated by F23 and F32 are the side walls parallel to and facing the first plane of symmetry SP1 of the second suspended mass 132 and, respectively, the third suspended mass 133.

All this having been said, the first spring element 141 has its ends fixed, respectively, to the side surfaces F13 and F31 of the first and third suspended masses 131, 133 so as to elastically couple the latter; moreover, the first spring element 141 is compliant in a direction parallel to the axis X.

The second spring element 142 has its ends fixed, respectively, to the side surfaces F24 and F42 of the second and fourth suspended masses 132, 134, so as to elastically couple the latter; moreover, the second spring element 142 is compliant in a direction parallel to the axis X.

The third spring element 143 has its ends fixed, respectively, to the side surfaces F23 and F32 of the second and third suspended masses 132, 133, so as to elastically couple the latter; moreover, the third spring element 143 is compliant in a direction parallel to the axis Y.

The fourth spring element 144 has its ends fixed, respectively, to the side surfaces F14 and F41 of the first and fourth suspended masses 131, 134 so as to elastically couple the latter; moreover, the fourth spring element 144 is compliant in a direction parallel to the axis Y.

With reference for brevity to the spring elements in contact with the third mobile mass 133, and therefore with reference to the first and third spring elements 141, 143 (but the same considerations apply also to the pairs of spring elements in contact with each one of the first, second, and fourth mobile masses 141, 142, 144), without this implying any loss of generality, we find what is described hereinafter. If VX denotes the side edge of the third mobile mass 133 parallel to the axis Z and facing the axis HX, the first and third spring elements 141, 143 contact, respectively, the side surfaces F31 and F32 in the proximity of the edge VX, albeit remaining at a distance from one another. Even though not illustrated, embodiments are possible in which the first and third spring elements 141, 143 are in contact with one another.

In practice, the first and third spring elements 141, 143 form, together with the third mobile mass 133, a first branch of the first spring structure, here designated by M1', which elastically couples the first and second mobile masses 131, 132. In addition, the second and fourth spring elements 142, 144 form, together with the fourth mobile mass 134, a second branch of the first spring structure M1', which also elastically couples the first and second mobile masses 131, 132 and is set, to a first approximation, parallel to the aforementioned first branch.

Likewise, the first and fourth spring elements 141, 144 form, together with the first mobile mass 131, a first branch of the second spring structure, here designated by M2', which elastically couples the third and fourth mobile masses 133, 134. In addition, the second and third spring elements 142, 143 form, together with the second mobile mass 132, a second branch of the second spring structure M2', which also elastically couples the third and fourth mobile masses 133, 134 and is set, to a first approximation, parallel to the corresponding first branch.

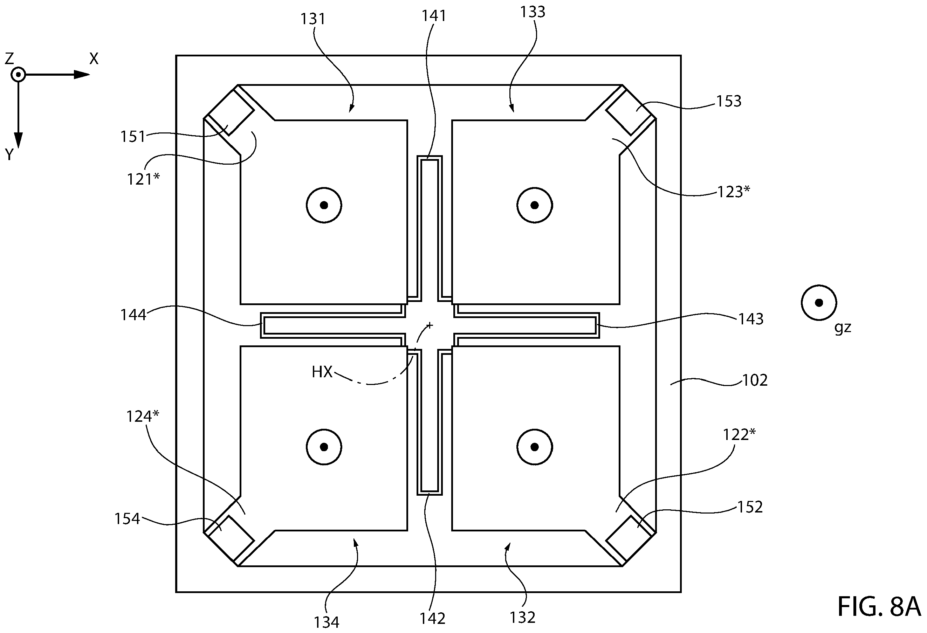

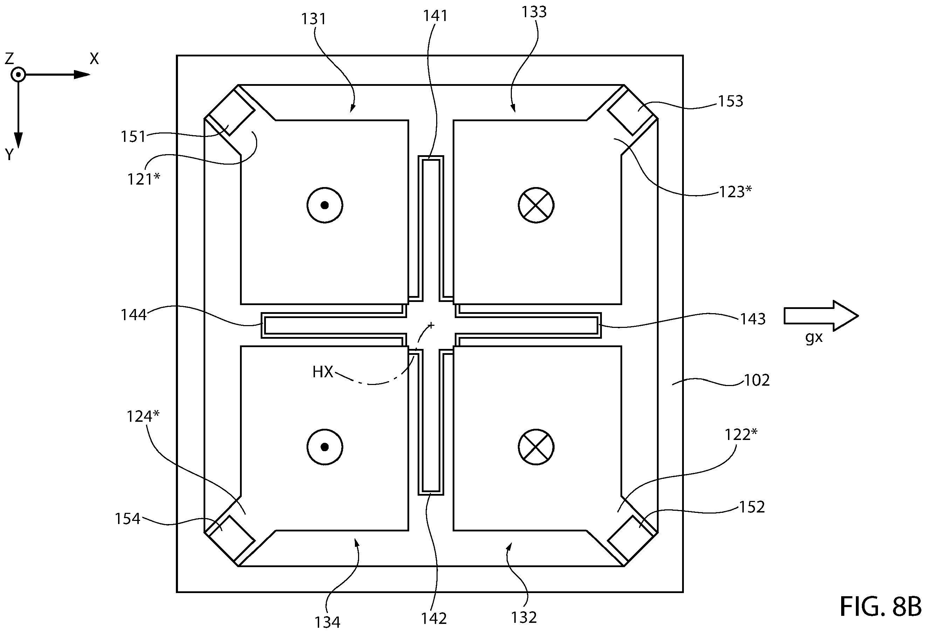

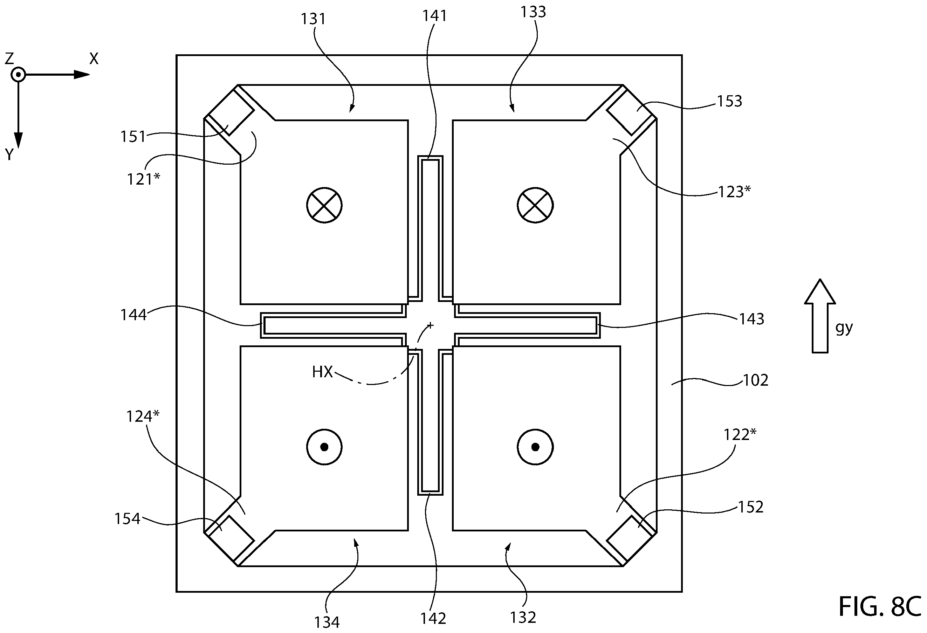

Operation of the MEMS accelerometer 101 is such that, in the case where it is subjected to an acceleration directed in a direction parallel to the axis Z, the first, second, third, and fourth mobile masses 131, 132, 133, 134 tend all together to rise or drop, according to the sense of the acceleration, as illustrated qualitatively in Figure 8A, where, in addition to referring, for example, to the case where the mobile masses tend to rise, the classic convention is adopted for representing the tip and the tail of vectors that indicate qualitatively the directions in which the first, second, third, and fourth mobile masses 131, 132, 133, 134 displace with respect to their resting positions; this convention is maintained also in the subsequent Figures 8B and 8C.

In the case where the MEMS accelerometer 1 is, instead, subjected to an acceleration directed along the axis X, but with opposite sense, what is illustrated in Figure 8B is found, where the arrow gx indicates the inertial acceleration to which the first, second, third, and fourth mobile masses 131, 132, 133, 134 are subjected. In detail, the first and fourth mobile masses 131, 134 tend to rise, causing compression of the first and fourth piezoelectric detection structures 151, 154, which generate, respectively, the voltages V1 and V4 with a same first polarity; instead, the second and third mobile masses 132, 133 tend to drop, causing tension of the second and third piezoelectric detection structures 153, 154, which generate, respectively, the voltages V2 and V3 with a same second polarity, opposite to the first polarity.

The aforementioned behaviour is may be explained recalling what has been described regarding the MEMS accelerometer 1 referred to in Figures 1-4 and noting that the inertial acceleration gx can be broken down into corresponding components in the direction H1' (equivalently, H2') and the direction H3' (equivalently, H4'), as well as noting that the first and second mobile masses 131, 132 and the first spring structure M1' behave, with reference to the components of the inertial accelerations in the directions H1' and H3', in the same way in which the first and second mobile masses 21, 22 and the first spring structure M1 of the MEMS accelerometer 1 illustrated in Figures 1-4 behave in the presence of inertial accelerations directed in a direction parallel to the axes X and Y. Furthermore, the third and fourth mobile masses 133, 134 and the second spring structure M2' behave, with reference to the components of inertial accelerations in the directions H1' and H3', in the same way in which the third and fourth mobile masses 23, 24 and the second spring structure M2 of the MEMS accelerometer 1 illustrated in Figures 1-4 behave in the presence of inertial accelerations directed in a direction parallel to the axes X and Y.

In the case where the MEMS accelerometer 1 is subjected to an acceleration directed along the axis Y, what is illustrated in Figure 8C is found, where the arrow gy indicates the inertial acceleration to which the first, second, third, and fourth mobile masses 131, 132, 133, 134 are subjected. In detail, the first and third mobile masses 131, 133 tend to drop, causing tension of the first and third piezoelectric detection structures 151, 153, which generate, respectively, the voltages V1 and V3 with the second polarity; instead, the second and fourth mobile masses 132, 134 tend to rise, causing compression of the second and fourth piezoelectric detection structures 152, 154, which generate, respectively, the voltages V2 and V4 with the first polarity.

By means of an electronic circuitry of a per se known type and not illustrated herein, it is thus possible to generate a signal sVZ2, for example equal to V1 + V2 + V3 + V4, which indicates the acceleration along Z. In addition, it is possible to generate a signal sVX' = (V1 + V4) - (V2 + V3) and a signal sVY' = (V2 + V4) - (V1 + V3), which indicate the accelerations along X and along Y, respectively.

The embodiment illustrated in Figures 7 and 8A-8C affords the same advantages as those described with reference to the embodiment illustrated in Figures 1-4. Moreover, also in this case, variants are possible in which, for example, the third and fourth mobile masses 133, 134 and the third and fourth cantilever elements 123, 124 are absent, or else variants in which, for example, the first and second mobile masses 131, 132 and the first and second cantilever elements 121, 122 are absent.

In general, the advantages that the present accelerometer affords emerge clearly from the foregoing description. In particular, the present accelerometer enables, for example, detection with a high sensitivity of vibrations in mutually orthogonal directions of stimulus, these vibrations possibly having relatively high frequencies, and at the same time makes it possible to benefit from a high immunity to the spurious static effects induced by spurious voltages.

Finally, it is clear that modifications and variations may be made to what has been described and illustrated herein, without thereby departing from the scope of the present invention, as defined in the annexed claims.

For instance, the shapes, and therefore also the corresponding sections, of the cantilever elements and of the mobile masses may differ from what has been described, as likewise the shapes of the piezoelectric detection structures and the arrangements of the latter with respect to the cantilever elements. For instance, in principle, the piezoelectric detection structures may be arranged underneath the deformable portions of the cantilever elements.

## Claims

1. A MEMS accelerometer comprising a supporting structure (2; 102) and at least one first deformable group (21*, 51; 121*, 151) and one second deformable group (22*, 52; 122*, 152), which include, respectively, a first deformable cantilever element (21*; 121*) and a second deformable cantilever element (22*; 122*), which are arranged in a direction parallel to a plane (XY) and each have a respective first end, which is fixed to the supporting structure (2; 102), and a respective second end; said first deformable group (21*, 51; 121*, 151) further comprising:
- a first piezoelectric detection structure (51; 151), which is mechanically coupled to the first deformable cantilever element (21*; 121*);
said second deformable group (22*, 52; 122*, 152) further comprising:
- a second piezoelectric detection structure (52; 152), which is mechanically coupled to the second deformable cantilever element (22*; 122*);
said MEMS accelerometer (1; 101) further comprising:
- a first mobile mass (31, 131) and a second mobile mass (32, 132), which are fixed, respectively, to the second end of the first deformable cantilever element (21*, 121*) and to the second end of the second deformable cantilever element (22*, 122*) and are staggered with respect to the first and second deformable cantilever elements (21*, 121*; 22*, 122*), respectively, in a vertical direction (Z) transverse with respect to said plane (XY); and
- a first elastic structure (M1, M1') configured to elastically couple the first and second mobile masses (31; 131; 32, 132);
and wherein the first and second deformable cantilever elements (21*, 22*; 121*, 122*) extend in a first direction of detection (H1, H2; H1', H2') and are opposite to one another, so that, in the presence of accelerations directed in a direction parallel to said first direction of detection (H1, H2; H1', H2'), the first and second deformable cantilever elements (21*, 22*; 121*, 122*) are subjected to first parallel and concordant bending moments; and wherein the first elastic structure (M1, M1') is compliant in a direction parallel to the first direction of detection (H1, H2; H1', H2') and is rigid parallel to the vertical direction (Z) .

2. The accelerometer according to claim 1, wherein the first and second deformable groups (21*, 51, 22*, 52; 121*, 151, 122*, 152) have, respectively, a first neutral axis (H1, H1') and a second neutral axis (H2, H2'), which extend in said first direction of detection (H1, H2; H1', H2').

3. The accelerometer according to claim 2, wherein the first and second piezoelectric detection structures (51, 52; 151, 152) are, respectively, staggered, in the vertical direction (Z), with respect to the first neutral axis (H1, H1') and to the second neutral axis (H2, H2') so that, in the presence of said first parallel and concordant bending moments, one of the first and second piezoelectric detection structures (51, 52; 151, 152) is subjected to tension, whereas the other is subjected to compression.

4. The accelerometer according to claim 3, wherein the first and second piezoelectric detection structures (51, 52; 151, 152) have planar shapes, arranged in a symmetrical way with respect to the first neutral axis (H1, H1') and to the second neutral axis (H2, H2'), respectively.

5. The accelerometer according to claim 3 or claim 4, wherein the first and second piezoelectric detection structures (51, 52; 151, 152) are arranged, respectively, on the first and second deformable cantilever elements (21*, 22*; 121*, 122*); and wherein the first and second mobile masses (31, 131; 32, 132) are vertically staggered downwards, with respect to the first and second deformable cantilever elements (21*, 121*; 22*, 122*).

6. The accelerometer according to any one of the preceding claims, further comprising a third deformable group (23*, 53; 123*, 153) and a fourth deformable group (24*, 54; 124*, 154), which include, respectively, a third deformable cantilever element (23*; 123*) and fourth deformable cantilever element (24*; 124*), which are arranged in a direction parallel to said plane (XY), extend in a second direction of detection (H3, H4; H3', H4'), are opposite to one another and each have a respective first end, which is fixed to the supporting structure (2; 102), and a respective second end; said third deformable group (23*, 53; 123*, 153) further comprising:
- a third piezoelectric detection structure (53; 153), which is mechanically coupled to the third deformable cantilever element (23*; 123*);
said fourth deformable group (24*, 54; 124*, 154) further comprising:
- a fourth piezoelectric detection structure (54; 154), which is mechanically coupled to the fourth deformable cantilever element (24*; 124*);
said MEMS accelerometer (1; 101) further comprising:
- a third mobile mass (33, 133) and a fourth mobile mass (34, 134), which are fixed, respectively, to the second end of the third deformable cantilever element (23*; 123*) and to the second end of the fourth deformable cantilever element (24*; 124*) and are, respectively, staggered, in the vertical direction (Z), with respect to the third and fourth deformable cantilever elements (23*, 123*; 24*, 124*) so that, in the presence of accelerations directed in a direction parallel to said second direction of detection (H3, H4; H3', H4'), the third and fourth deformable cantilever elements (23*, 123*; 24*, 124*) are subjected to second parallel and concordant bending moments;
said accelerometer (7; 107) further comprising a second elastic structure (M2, M2') configured to elastically couple the third and fourth mobile masses (33, 133; 34, 134).

7. The accelerometer according to claim 6, wherein the third and fourth deformable groups (23*, 53, 24*, 54; 123*, 153, 124*, 154) have, respectively, a third neutral axis (H3, H3') and a fourth neutral axis (H4, H4'), which extend in the second direction of detection (H3, H4; H3', H4').

8. The accelerometer according to claim 7, wherein the third and fourth piezoelectric detection structures (53, 54; 153, 154) are, respectively, staggered, in the vertical direction (Z), with respect to the third neutral axis (H3, H3') and to the fourth neutral axis (H4, H4') so that, in the presence of said second parallel and concordant bending moments, one of the third and fourth piezoelectric detection structures (53, 54; 153, 1524) is subjected to tension, whereas the other is subjected to compression.

9. The accelerometer according to claim 8, wherein the third and fourth piezoelectric detection structures (53, 54; 153, 154) have planar shapes, arranged in a symmetrical way with respect, respectively, to the third neutral axis (H3, H3') and to the fourth neutral axis (H4, H4').

10. The accelerometer according to any one of claims 6 to 9, wherein the second elastic structure (M2, M2') is compliant in a direction parallel to the second direction of detection (H3, H4; H3', H4') and is rigid parallel to the vertical direction (Z).

11. The accelerometer according to any one of claims 6 to 10, wherein the first direction of detection (H1, H2; H1', H2') and the second direction of detection (H3, H4; H3', H4') are perpendicular to one another and to the vertical direction (Z).

12. The accelerometer according to claim 11, wherein the first and second mobile masses (31, 32; 131, 132) have centroids, respectively, staggered, in the first direction of detection (H1, H2; H1', H2'), with respect to the second ends of the first and second deformable cantilever elements (21*, 121*; 22*, 121*) so that, in the presence of accelerations directed in a direction parallel to the vertical direction (Z), the first and second deformable cantilever elements (21*, 121*; 22*, 121*) are subjected to parallel and opposite third bending moments; and wherein the third and fourth mobile masses (33, 34; 133, 134) have centroids, respectively, staggered, in the second direction of detection (H3, H4; H3', H4'), with respect to the second ends of the third and fourth deformable cantilever elements (23*, 123*; 24*, 124*) so that, in the presence of accelerations directed in a direction parallel to the vertical direction (Z), the third and fourth deformable cantilever elements (23*, 123*; 24*, 124*) are subjected to parallel and opposite fourth bending moments.

13. The accelerometer according to claim 11 or claim 12, wherein the first, second, third, and fourth mobile masses (131, 132, 133, 134) are arranged in a square so as to be set two by two parallel alternately to a first reference axis (X) or a second reference axis (Y), which are orthogonal to one another and are perpendicular to the vertical direction (Z); and wherein said first and second directions of detection (H1', H2'; H3', H4') are both transverse with respect to said first and second reference axes (X,Y); said accelerometer (107) further comprising:
- a first spring (141), which is compliant in a direction parallel to the first reference axis (X) and elastically couples the first and third mobile masses (131, 133) ;
- a second spring (142), which is compliant in a direction parallel to the first reference axis (X) and elastically couples the second and fourth mobile masses (132, 134);
- a third spring (143), which is compliant in a direction parallel to the second reference axis (Y) and elastically couples the second and third mobile masses (132, 133); and
- a fourth spring (144), which is compliant in a direction parallel to the second reference axis (Y) and elastically couples the first and fourth mobile masses (131, 134);
and wherein the first elastic structure (M1') comprises a respective first branch, which includes the first and third springs (141, 143) and the third mobile mass (133), and a respective second branch, which includes the second and fourth springs (142, 144) and the fourth mobile mass (134); and wherein the second elastic structure (M2') comprises a respective first branch, which includes the first and fourth springs (141, 144) and the first mobile mass (131), and a respective second branch, which includes the second and third springs (142, 143) and the second mobile mass (133).

14. The accelerometer according to claim 11 or claim 12, wherein the first, second, third, and fourth mobile masses (31, 32, 33, 34) have a rhomboidal arrangement; and wherein the first and second spring structures (M1, M2) comprise, respectively, a first arm (41, 42) and a second arm (43, 44), each having a folded elongated shape and being arranged to form a cross.

## Patentansprüche

1. MEMS-Beschleunigungsmesser, eine Tragstruktur (2; 102) umfassend, und mindestens eine erste verformbare Gruppe (21*, 51; 121*, 151) und eine zweite verformbare Gruppe (22*, 52; 122*, 152), die jeweils ein erstes verformbares Auslegerelement (21*; 121*) und ein zweites verformbares Auslegerelement (22*; 122*) enthalten, die in einer Richtung parallel zu einer Ebene (XY) angeordnet sind, und jeweils ein erstes Ende, das an der Tragstruktur (2; 102) befestigt ist, und jeweils ein zweites Ende aufweisen; wobei die erste verformbare Gruppe (21*, 51; 121*, 151) ferner umfasst:
- eine erste piezoelektrische Detektionsstruktur (51; 151), die mechanisch mit dem ersten verformbaren Auslegerelement (21*; 121*) gekoppelt ist;
wobei die zweite verformbare Gruppe (22*, 52; 122*, 152) ferner umfasst:
- eine zweite piezoelektrische Detektionsstruktur (52; 152), die mechanisch mit dem zweiten verformbaren Auslegerelement (22*; 122*) gekoppelt ist;
wobei der MEMS-Beschleunigungsmesser (1; 101) ferner umfasst:
- eine erste bewegliche Masse (31, 131) und eine zweite bewegliche Masse (32, 132), die jeweils am zweiten Ende des ersten verformbaren Auslegerelements (21*, 121*) und am zweiten Ende des zweiten verformbaren Auslegerelements (22*, 122*) befestigt und in Bezug auf das erste und das zweite verformbare Auslegerelement (21*, 121*, 22*, 122*) versetzt angeordnet sind, jeweils in einer vertikalen Richtung (Z) quer zur Ebene (XY); und
- eine erste elastische Struktur (M1, M1'), die konfiguriert ist, um die erste und die zweite bewegliche Masse (31; 131; 32, 132) elastisch zu koppeln;
und wobei sich das erste und zweite verformbare Auslegerelement (21*, 22*; 121*, 122*) in einer ersten Detektionsrichtung (H1, H2; H1', H2') erstrecken und einander gegenüberliegen, so dass bei Vorhandensein von Beschleunigungen, die in eine Richtung parallel zur ersten Detektionsrichtung (H1, H2; H1', H2') gerichtet sind, die ersten und zweiten verformbaren Auslegerelemente (21*, 22*; 121*, 122*) ersten parallelen und übereinstimmenden Biegemomenten ausgesetzt sind; und wobei die erste elastische Struktur (M1, M1') in einer Richtung parallel zur ersten Detektionsrichtung (H1, H2; H1', H2') nachgiebig ist und parallel zur vertikalen Richtung (Z) starr ist.

2. Beschleunigungsmesser nach Anspruch 1, wobei die erste und die zweite verformbare Gruppe (21*, 51, 22*, 52; 121*, 151, 122*, 152) jeweils eine erste neutrale Achse (H1, H1') und eine zweite neutrale Achse (H2, H2') aufweisen, die sich in die erste Detektionsrichtung (H1, H2; H1', H2') erstrecken.

3. Beschleunigungsmesser nach Anspruch 2, wobei die erste und die zweite piezoelektrische Detektionsstruktur (51, 52; 151, 152) jeweils in vertikaler Richtung (Z) in Bezug auf die erste neutrale Achse (H1, H1') und die zweite neutrale Achse (H2, H2') versetzt sind, so dass bei Vorhandensein der ersten parallelen und übereinstimmenden Biegemomente eine der ersten und der zweiten piezoelektrischen Detektionsstrukturen (51, 52; 151, 152) einer Spannung ausgesetzt ist, während die andere einer Kompression ausgesetzt ist.

4. Beschleunigungsmesser nach Anspruch 3, wobei die erste und die zweite piezoelektrische Detektionsstruktur (51, 52; 151, 152) ebene Formen aufweisen, die symmetrisch in Bezug auf die jeweils erste neutrale Achse (H1, H1') beziehungsweise auf die zweite neutrale Achse (H2, H2') angeordnet sind.

5. Beschleunigungsmesser nach Anspruch 3 oder Anspruch 4, wobei die erste und die zweite piezoelektrische Detektionsstruktur (51, 52; 151, 152) jeweils an den ersten und zweiten verformbaren Auslegerelementen (21*, 22*; 121*, 122*) angeordnet sind; und wobei die erste und die zweite bewegliche Masse (31, 131; 32, 132) vertikal nach unten versetzt sind, in Bezug auf die ersten und zweiten verformbaren Auslegerelemente (21*, 121*; 22*, 122*).

6. Beschleunigungsmesser nach einem der vorhergehenden Ansprüche, ferner eine dritte verformbare Gruppe (23*, 53; 123*, 153) und eine vierte verformbare Gruppe (24*, 54; 124*, 154) umfassend, die jeweils ein drittes verformbares Auslegerelement (23*; 123*) und ein viertes verformbares Auslegerelement (24*; 124*) enthalten, die in einer Richtung parallel zur Ebene (XY) angeordnet sind, sich in einer zweiten Detektionsrichtung (H3, H4; H3', H4') erstrecken, einander gegenüberliegen und jeweils ein erstes Ende aufweisen, das an der Tragstruktur (2; 102) befestigt ist, und jeweils ein zweites Ende; wobei die dritte verformbare Gruppe (23*, 53; 123*, 153) ferner umfasst:
- eine dritte piezoelektrische Detektionsstruktur (53; 153), die mechanisch mit dem dritten verformbaren Auslegerelement (23*; 123*) gekoppelt ist;
wobei die vierte verformbare Gruppe (24*, 54; 124*, 154) ferner umfasst:
- eine vierte piezoelektrische Detektionsstruktur (54; 154), die mechanisch mit dem vierten verformbaren Auslegerelement (24*; 124*) gekoppelt ist;
wobei der MEMS-Beschleunigungsmesser (1; 101) ferner umfasst:
- eine dritte bewegliche Masse (33, 133) und eine vierte bewegliche Masse (34, 134), die jeweils am zweiten Ende des dritten verformbaren Auslegerelements (23*; 123*) und am zweiten Ende des vierten verformbaren Auslegerelements (24*; 124*) befestigt sind, und jeweils in vertikaler Richtung (z) in Bezug auf das dritte und vierte verformbare Auslegerelement (23*, 123*; 24*, 124*) versetzt sind, so dass bei Vorhandensein von Beschleunigungen, die in eine Richtung parallel zur zweiten Detektionsrichtung (H3, H4; H3', H4') gerichtet sind, das dritte und vierte verformbare Auslegerelement (23*, 123*; 24*, 124*) zweiten parallelen und übereinstimmenden Biegemomenten ausgesetzt sind;
wobei der Beschleunigungsmesser (7; 107) ferner eine zweite elastische Struktur (M2, M2') umfasst, die konfiguriert ist, um die dritte und vierte bewegliche Masse (33, 133; 34, 134) elastisch zu koppeln.

7. Beschleunigungsmesser nach Anspruch 6, wobei die dritte und vierte verformbare Gruppe (23*, 53, 24*, 54; 123*, 153, 124*, 154) jeweils eine dritte neutrale Achse (H3, H3') und eine vierte neutrale Achse (H4, H4') aufweisen, die sich in die zweite Detektionsrichtung (H3, H4; H3', H4') erstrecken.

8. Beschleunigungsmesser nach Anspruch 7, wobei die dritte und vierte piezoelektrische Detektionsstruktur (53, 54; 153, 154) jeweils in vertikaler Richtung (Z) in Bezug auf die dritte neutrale Achse (H3, H3') und die vierte neutrale Achse (H4, H4') versetzt sind, so dass bei Vorhandensein der zweiten parallelen und übereinstimmenden Biegemomente eine der dritten und vierten piezoelektrischen Detektionsstrukturen (53, 54; 153, 154) einer Spannung ausgesetzt ist, während die andere einer Kompression ausgesetzt ist.

9. Beschleunigungsmesser nach Anspruch 8, wobei die dritte und vierte piezoelektrische Detektionsstruktur (53, 54; 153, 154) ebene Formen aufweisen, die jeweils symmetrisch in Bezug auf die dritte neutrale Achse (H3, H3') und die vierte neutrale Achse (H4, H4') angeordnet sind.

10. Beschleunigungsmesser nach einem der Ansprüche 6 bis 9, wobei die zweite elastische Struktur (M2, M2') in einer Richtung parallel zur zweiten Detektionsrichtung (H3, H4; H3', H4') nachgiebig ist und parallel zur vertikalen Richtung (Z) starr ist.

11. Beschleunigungsmesser nach einem der Ansprüche 6 bis 10, wobei die erste Detektionsrichtung (H1, H2; H1', H2') und die zweite Detektionsrichtung (H3, H4; H3', H4') senkrecht zueinander und zur vertikalen Richtung (Z) sind.

12. Beschleunigungsmesser nach Anspruch 11, wobei die erste und die zweite bewegliche Masse (31, 32; 131, 132) Schwerpunkte aufweisen, die jeweils in der ersten Detektionsrichtung (H1, H2; H1', H2') in Bezug auf die zweiten Enden der ersten und zweiten verformbaren Auslegerelemente (21*, 121*; 22*, 121*) versetzt sind, so dass bei Vorhandensein von Beschleunigungen, die in eine Richtung parallel zur vertikalen Richtung (Z) gerichtet sind, das erste und zweite verformbare Auslegerelement (21*, 121*; 22*, 121*) parallelen und entgegengesetzten dritten Biegemomenten ausgesetzt sind; und wobei die dritte und vierte bewegliche Masse (33, 34; 133, 134) Schwerpunkte aufweisen, die jeweils in der zweiten Detektionsrichtung (H3, H4; H3', H4') in Bezug auf die zweiten Enden der dritten und vierten verformbaren Auslegerelemente (23*, 123*; 24*, 124*) versetzt sind, so dass bei Vorhandensein von Beschleunigungen, die in eine Richtung parallel zur vertikalen Richtung (Z) gerichtet sind, das dritte und vierte verformbare Auslegerelement (23*, 123*; 24*, 124*) parallelen und entgegengesetzten vierten Biegemomenten ausgesetzt sind.

13. Beschleunigungsmesser nach Anspruch 11 oder Anspruch 12, wobei die erste, zweite, dritte und vierte bewegliche Masse (131, 132, 133, 134) in einem Quadrat angeordnet sind, so dass sie paarweise parallel abwechselnd zu einer ersten Referenzachse (X) oder einer zweiten Referenzachse (Y) eingestellt sind, die orthogonal zueinander und senkrecht zur vertikalen Richtung (Z) liegen; und wobei die erste und die zweite Detektionsrichtung (H1', H2'; H3', H4') beide quer zur ersten und zweiten Referenzachse (X, Y) liegen; wobei der Beschleunigungsmesser (107) ferner umfasst:
- eine erste Feder (141), die in einer Richtung parallel zur ersten Referenzachse (X) nachgiebig ist, und die erste und dritte bewegliche Masse (131, 133) elastisch koppelt;
- eine zweite Feder (142), die in einer Richtung parallel zur ersten Referenzachse (X) nachgiebig ist, und die zweite und vierte bewegliche Masse (132, 134) elastisch koppelt;
- eine dritte Feder (143), die in einer Richtung parallel zur zweiten Referenzachse (Y) nachgiebig ist, und die zweite und dritte bewegliche Masse (132, 133) elastisch koppelt; und
- eine vierte Feder (144), die in einer Richtung parallel zur zweiten Referenzachse (Y) nachgiebig ist, und die erste und vierte bewegliche Masse (131, 134) elastisch koppelt; und wobei die erste elastische Struktur (M1') einen jeweiligen ersten Zweig umfasst, der die erste und dritte Feder (141, 143) und die dritte bewegliche Masse (133) enthält, und einen jeweiligen zweiten Zweig, der die zweite und vierte Feder (142, 144) und die vierte bewegliche Masse (134) enthält;
und wobei die zweite elastische Struktur (M2') einen jeweiligen ersten Zweig umfasst, der die erste und vierte Feder (141, 144) und die erste bewegliche Masse (131) enthält, und einen jeweiligen zweiten Zweig, der die zweite und dritte Feder (142, 143) und die zweite bewegliche Masse (133) enthält.

14. Beschleunigungsmesser nach Anspruch 11 oder Anspruch 12, wobei die erste, zweite, dritte und vierte bewegliche Masse (31, 32, 33, 34) eine rautenförmige Anordnung aufweisen; und wobei die erste und die zweite Federstruktur (M1, M2) jeweils einen ersten Arm (41, 42) und einen zweiten Arm (43, 44) umfassen, die jeweils eine gefaltete längliche Form aufweisen und so angeordnet sind, dass sie ein Kreuz bilden.

## Revendications

1. Accéléromètre MEMS comprenant une structure de support (2 ; 102) et au moins un premier groupe déformable (21*, 51 ; 121*, 151) et un deuxième groupe déformable (22*, 52 ; 122*, 152), qui comprennent respectivement un premier élément en porte-à-faux déformable (21* ; 121*) et un deuxième élément en porte-à-faux déformable (22* ; 122*), qui sont disposés dans une direction parallèle à un plan (XY) et ayant chacun une première extrémité respective, qui est fixée à la structure de support (2 ; 102), et une deuxième extrémité respective ; ledit premier groupe déformable (21*, 51 ; 121*, 151) comprenant en outre :
- une première structure de détection piézoélectrique (51 ; 151), qui est accouplée mécaniquement au premier élément en porte-à-faux déformable (21* ; 121*) ;
ledit deuxième groupe déformable (22*, 52 ; 122*, 152) comprenant en outre :
- une deuxième structure de détection piézoélectrique (52 ; 152), qui est accouplée mécaniquement au deuxième élément en porte-à-faux déformable (22* ; 122*) ;
ledit accéléromètre MEMS (1 ; 101) comprenant en outre :
- une première masse mobile (31, 131) et une deuxième masse mobile (32, 132), qui sont fixées, respectivement, à la deuxième extrémité du premier élément en porte-à-faux déformable (21* ; 121*) et à la deuxième extrémité du deuxième élément en porte-à-faux déformable (22* ; 122*) et qui sont décalées par rapport aux premier et deuxième éléments en porte-à-faux déformables (21*, 121* ; 22* ; 122*), respectivement, dans une direction verticale (Z) transversale par rapport audit plan (XY) ; et
- une première structure élastique (M1, M1') configurée pour accoupler élastiquement les première et deuxième masses mobiles (31 ; 131 ; 32, 132) ;
et dans lequel les premier et deuxième éléments en porte-à-faux déformables (21*, 22* ; 121*, 122*) s'étendent dans une première direction de détection (H1, H2 ; H1', H2') et sont en face l'un de l'autre, de sorte qu'en présence d'accélérations orientées dans une direction parallèle à ladite première direction de détection (H1, H2 ; H1', H2'), les premier et deuxième éléments en porte-à-faux déformables (21*, 22* ; 121*, 122*) sont soumis à des premiers moments de flexion parallèles et concordants ; et dans lequel la première structure élastique (M1, M1') est flexible dans une direction parallèle à la première direction de détection (H1, H2 ; H1', H2') et est rigide parallèlement à la direction verticale (Z).

2. Accéléromètre selon la revendication 1, dans lequel les premier et deuxième groupes déformables (21*, 51, 22*, 52 ; 121*, 151, 122*, 152) ont respectivement un premier axe neutre (H1, H1') et un deuxième axe neutre (H2, H2'), qui s'étendent dans ladite première direction de détection (H1, H2 ; H1', H2').

3. Accéléromètre selon la revendication 2, dans lequel les première et deuxième structures de détection piézoélectriques (51, 52 ; 151, 152) sont décalées respectivement dans la direction verticale (Z), par rapport au premier axe neutre (H1, H1') et au deuxième axe neutre (H2, H2') de sorte que, en présence desdits premiers moments de flexion parallèles et concordants, l'une des première et deuxième structures de détection piézoélectriques (51, 52 ; 151, 152) est soumise à une traction, tandis que l'autre est soumise à une compression.

4. Accéléromètre selon la revendication 3, dans lequel les première et deuxième structures de détection piézoélectriques (51, 52 ; 151, 152) ont des formes planes, disposées de façon symétrique respectivement par rapport au premier axe neutre (H1, H1') et au deuxième axe neutre (H2, H2').

5. Accéléromètre selon la revendication 3 ou 4, dans lequel les première et deuxième structures de détection piézoélectriques (51, 52 ; 151, 152) sont placées respectivement sur les premier et deuxième éléments en porte-à-faux déformables (21*, 22* ; 121*, 122*) ; et dans lequel les première et deuxième masses mobiles (31 ; 131 ; 32, 132) sont décalées verticalement vers le bas, par rapport aux premier et deuxième éléments en porte-à-faux déformables (21^{∗}, 121^{∗} ; 22^{∗}, 122^{∗}).

6. Accéléromètre selon l'une quelconque des revendications précédentes, comprenant en outre un troisième groupe déformable (23*, 53 ; 123*, 153) et un quatrième groupe déformable (24*, 54 ; 124*, 154), qui comprennent respectivement un troisième élément en porte-à-faux déformable (23* ; 123*) et un quatrième élément en porte-à-faux déformable (24* ; 124*), qui sont disposés dans une direction parallèle audit plan (XY), qui s'étendent dans une deuxième direction de détection (H3, H4 ; H3', H4'), qui sont en face l'un de l'autre et ayant chacun une première extrémité respective, qui est fixée à la structure de support (2 ; 102), et une deuxième extrémité respective ; ledit troisième groupe déformable (23*, 53 ; 123*, 153) comprenant en outre :
- une troisième structure de détection piézoélectrique (53 ; 153), qui est accouplée mécaniquement au troisième élément en porte-à-faux déformable (23* ; 123*) ;
ledit quatrième groupe déformable (24*, 54 ; 124*, 154) comprenant en outre :
- une quatrième structure de détection piézoélectrique (54 ; 154), qui est accouplée mécaniquement au quatrième élément en porte-à-faux déformable (24* ; 124*) ;
ledit accéléromètre MEMS (1 ; 101) comprenant en outre :
- une troisième masse mobile (33, 133) et une quatrième masse mobile (34, 134), qui sont fixées, respectivement, à la deuxième extrémité du troisième élément en porte-à-faux déformable (23* ; 123*) et à la deuxième extrémité du quatrième élément en porte-à-faux déformable (24* ; 124*) et qui sont décalées respectivement dans la direction verticale (Z) par rapport aux troisième et quatrième éléments en porte-à-faux déformables (23*, 123* ; 24* ; 124*), de sorte qu'en présence d'accélérations orientées dans une direction parallèle à ladite deuxième direction de détection (H3, H4 ; H3', H4'), les troisième et quatrième éléments en porte-à-faux déformables (23*, 123* ; 24*, 124*) sont soumis à des deuxièmes moments de flexion parallèles et concordants ;
ledit accéléromètre (7 ; 107) comprenant en outre une deuxième structure élastique (M2, M2') configurée pour accoupler élastiquement les troisième et quatrième masses mobiles (33, 133 ; 34, 134).

7. Accéléromètre selon la revendication 6, dans lequel les troisième et quatrième groupes déformables (23*, 53, 24*, 54 ; 123*, 153, 124*, 154) ont respectivement un troisième axe neutre (H3, H3') et un quatrième axe neutre (H4, H4'), qui s'étendent dans la deuxième direction de détection (H3, H4 ; H3', H4').

8. Accéléromètre selon la revendication 7, dans lequel les troisième et quatrième structures de détection piézoélectriques (53, 54 ; 153, 154) sont décalées respectivement dans la direction verticale (Z), par rapport au troisième axe neutre (H3, H3') et au quatrième axe neutre (H4, H4') de sorte que, en présence desdits deuxièmes moments de flexion parallèles et concordants, l'une des troisième et quatrième structures de détection piézoélectriques (53, 54 ; 153, 1524) est soumise à une traction, tandis que l'autre est soumise à une compression.

9. Accéléromètre selon la revendication 8, dans lequel les troisième et quatrième structures de détection piézoélectriques (53, 54 ; 153, 154) ont des formes planes, disposées de façon symétrique respectivement par rapport au troisième axe neutre (H3, H3') et au quatrième axe neutre (H4, H4').

10. Accéléromètre selon l'une quelconque des revendications 6 à 9, dans lequel la deuxième structure élastique (M2, M2') est flexible dans une direction parallèle à la deuxième direction de détection (H3, H4 ; H3', H4') et est rigide parallèlement à la direction verticale (Z).

11. Accéléromètre selon l'une quelconque des revendications 6 à 10, dans lequel la première direction de détection (H1, H2 ; H1', H2') et la deuxième direction de détection (H3, H4 ; H3', H4') sont perpendiculaires entre elles et à la direction verticale (Z).

12. Accéléromètre selon la revendication 11, dans lequel les première et deuxième masses mobiles (31, 32 ; 131, 132) ont des centroïdes décalés respectivement dans la première direction de détection (H1, H2 ; H1', H2') par rapport aux deuxièmes extrémités des premier et deuxième éléments en porte-à-faux déformables (21^{∗}, 121^{∗} ; 22^{∗}, 121^{∗}), de sorte qu'en présence d'accélérations orientées dans une direction parallèle à la direction verticale (Z), les premier et deuxième éléments en porte-à-faux déformables (21^{∗}, 121^{∗} ; 22^{∗}, 121^{∗}) sont soumis à des troisièmes moments de flexion parallèles et opposés ; et dans lequel les troisième et quatrième masses mobiles (33, 34 ; 133, 134) ont des centroïdes décalés respectivement dans la deuxième direction de détection (H3, H4 ; H3', H4') par rapport aux deuxièmes extrémités des troisième et quatrième éléments en porte-à-faux déformables (23*, 123* ; 24*, 124*), de sorte qu'en présence d'accélérations orientées dans une direction parallèle à la direction verticale (Z), les troisième et quatrième éléments en porte-à-faux déformables (23*, 123* ; 24*, 124*) sont soumis à des quatrièmes moments de flexion parallèles et opposés.

13. Accéléromètre selon la revendication 11 ou 12, dans lequel les première, deuxième, troisième et quatrième masses mobiles (131, 132, 133, 134) sont disposées en carré afin d'être placées deux par deux parallèlement alternativement à un premier axe de référence (X) ou à un deuxième axe de référence (Y), qui sont orthogonaux entre eux et qui sont perpendiculaires à la direction verticale (Z) ; et dans lequel lesdites première et deuxième directions de détection (H1', H2' ; H3', H4') sont toutes deux transversales par rapport auxdits premier et deuxième axes de référence (X, Y) ; ledit accéléromètre (107) comprenant en outre :
- un premier ressort (141), qui est flexible dans une direction parallèle au premier axe de référence (X) et qui accouple élastiquement les première et troisième masses mobiles (131, 133) ;
- un deuxième ressort (142), qui est flexible dans une direction parallèle au premier axe de référence (X) et qui accouple élastiquement les deuxième et quatrième masses mobiles (132, 134) ;
- un troisième ressort (143), qui est flexible dans une direction parallèle au deuxième axe de référence (Y) et qui accouple élastiquement les deuxième et troisième masses mobiles (132, 133) ; et
- un quatrième ressort (144), qui est flexible dans une direction parallèle au deuxième axe de référence (Y) et qui accouple élastiquement les première et quatrième masses mobiles (131, 134) ;
et dans lequel la première structure élastique (M1') comprend une première branche respective, qui comporte les premier et troisième ressorts (141, 143) et la troisième masse mobile (133), et une deuxième branche respective, qui comporte les deuxième et quatrième ressorts (142, 144) et la quatrième masse mobile (134) ; et dans lequel la deuxième structure élastique (M2') comprend une première branche respective, qui comporte les premier et quatrième ressorts (141, 144) et la première masse mobile (131), et une deuxième branche respective, qui comporte les deuxième et troisième ressorts (142, 143) et la deuxième masse mobile (133).

14. Accéléromètre selon la revendication 11 ou 12, dans lequel les première, deuxième, troisième et quatrième masses mobiles (31, 32, 33, 34) ont un agencement rhomboïde ; et dans lequel les première et deuxième structures de ressort (M1, M2) comprennent respectivement un premier bras (41, 42) et un deuxième bras (43, 44), chacun ayant une forme allongée pliée et étant disposé de façon à former une croix.
